Europäisches Patentamt

(19) European Patent Office

Office européen des brevets

(11) Publication number: **0 006 550**
**B1**

(12) **EUROPEAN PATENT SPECIFICATION**

(45) Date of publication of patent specification: **22.12.82**

(21) Application number: **79101962.3**

(22) Date of filing: **15.06.79**

(51) Int. Cl.³: **G 06 F 13/02,**
**G 11 C 19/28,**
**G 06 F 11/10,**
**G 06 F 11/20, G 06 F 11/18**

(54) **Self-correcting and reconfigurable solid-state mass-memory organized in bits.**

(30) Priority: **28.06.78 IT 6851678**

(43) Date of publication of application:
**09.01.80 Bulletin 80/1**

(45) Publication of the grant of the patent:
**22.12.82 Bulletin 82/51**

(84) Designated Contracting States:
**DE FR GB NL SE**

(56) References cited:
**FR - A - 2 141 094**
**GB - A - 2 016 180**
**US - A - 3 737 870**

**COMPUTER, vol. 10, no. 7, July 1977, pages 18—25, Long Beach (US) PANIGRAHI: "The implications of electronic serial memories".**
**PROCEEDINGS OF THE IEEE, vol. 63, no. 8, August 1975, pages 1136—1147. New York (US) HODGES: "A review and projection of semiconductor components for digital storage".**

(73) Proprietor: **CSELT Centro Studi e Laboratori Telecomunicazioni S.p.A.**
**Via Guglielmo Reiss Romoli, 274**
**I-10148 Turin (IT)**

(72) Inventor: **Bernardini, Vincenzo**
**Via Boston, 92/23**
**Turin (IT)**
Inventor: **Garetti, Enzo**
**Via Monte Vodice, 18**
**Turin (IT)**
Inventor: **Manfreddi, Renato**
**C.so Peschiera, 272**
**Turin (IT)**

(74) Representative: **Riederer Freiherr von Paar zu Schönau, Anton**
**Müllerstrasse 31**
**D-8000 München 5 (DE)**

Courier Press, Leamington Spa, England.

IEEE TRANSACTIONS ON COMPUTERS, vol. C-25, no. 6, June 1976 pages 557—568, New York (US) CARTER et al. "Implementation of an experimental fault-tolerant memory system".
IEEE TRANSACTIONS ON MAGNETICS, vol. MAG 13, no. 5, September 1977, pages 1631—1635, New York (US) MURAKAMI: "Memory organization using imperfect bubble chips",
INTERNATIONAL SYMPOSIUM ON FAULT TOLERANT COMPUTING, June 20—22, 1973, Polo Alto, published by IEEE, New York (US) MASTRANADI: "Fault-tolerant storage systems design studies", pages 41—45.
ELECTRONIC DESIGN, vol. 26, no. 17, August 1978, pages 88—94, Littleton, (US) SITRICK: "Single-chip CCD memory really delivers".

## Self-correcting and reconfigurable solid-state mass-memory organized in bits

The invention relates to a self-correcting and reconfigurable solid-state mass-memory organized in bits, consisting of at least one memory unit comprising a first group of memory modules each intended to store one bit of a plurality of words consisting of information bits and redundancy bits necessary to self-correction, one or more spare memory modules which in case of failure have to replace one or more modules in the first group, and at least a control module controlling the data exchange between the memory unit and a controller and generating timing and addressing signals for the memory unit and supervising the operation of the memory unit by detecting and correcting errors, said control module comprising also switching means for switching out a failed memory module and switching in a spare memory module.

It is known that present stored-program control systems have memories organized in a hierarchic structure, providing fast-access memories for on-line programs and data (main memories), followed by other memories, generally with slower access, for programs and data of less immediate and frequent use (mass memories). These memories often act also as auxiliary memories for the main memories, that is they contain also semi-permanent data and on-line programs necessary to allow the control system to be put again into the usual service when a failure occurs in the main memories.

Till now mass-memories consisted usually of disk-units, magnetic tapes or drums, because, owing to the state of the art, these solutions alone could ensure large storage capacity at reduced cost.

Anyway magnetic memories present some inconveniences:

— they can not attain sufficiently high operating speed, chiefly fast access time;
— they can not ensure a sufficiently high "system availability" (intended as probability of finding the system operating at any moment), owing to the frequent interventions necessary to maintain the efficiency of the units; this feature is emphasized by the fact that the magnetic units have moving mechanical parts, that require an initial running-in and present wear phenomena that can also require preventive maintenance.

For these reasons the studies aimed to obtain memories of different types mainly for small and middle capacity (for instance up to 10 million-words) have proved to be of main importance; owing to the development in the techniques used to build solid-state components, the studies have been directed towards components of very high-scale integration, and more particularly towards charge coupled devices.

A memory of this type with operating characteristics very similar to those of a disk-unit is already commercially available.

Such a solid-state memory intrinsically presents high operating speed as well as good reliability and easy-maintenance characteristics; moreover it presents good modularity, that is at the initial rather small units may be combined to form larger units according to the requirements.

This memory presents some inconveniences that make it not so apt to be used in telecommunications system control: more particularly it provides no error self-correcting possibility and is organized by "bytes", that is by 8-bit words.

But in telecommunications applications the control system must be in service continuously: then it is important for the mass-memory to be provided with self-correcting means preventing the system to be put out-of-service during the time necessary to detect the cause of the error and to remedy it; self-correction provides an efficient protection of the stored data, so that said data do not get lost and can be used by a possible auxiliary unit put into service by a reconfiguration system.

In fact, processing systems with severe reliability requirements need usually a plurality of mass-memory units. On the contrary, if redundant parts for replacing the failed units, when a failure occurs, are provided within one of those memory units, the reliability requirements of the processing system could be met by a single mass-memory unit, allowing a remarkable saving.

Moreover, for both speed and flexibility purposes, in the telecommunications field or more generally in the process control, the control system must operate on words of 16 bits or more.

To achieve flexibility on the real length of the words, number of redundancy bits necessary for self-correction and number of spare parts, it is important that a memory organized by bits is provided: the memory consists of many modules and each one stores one bit of a plurality of words.

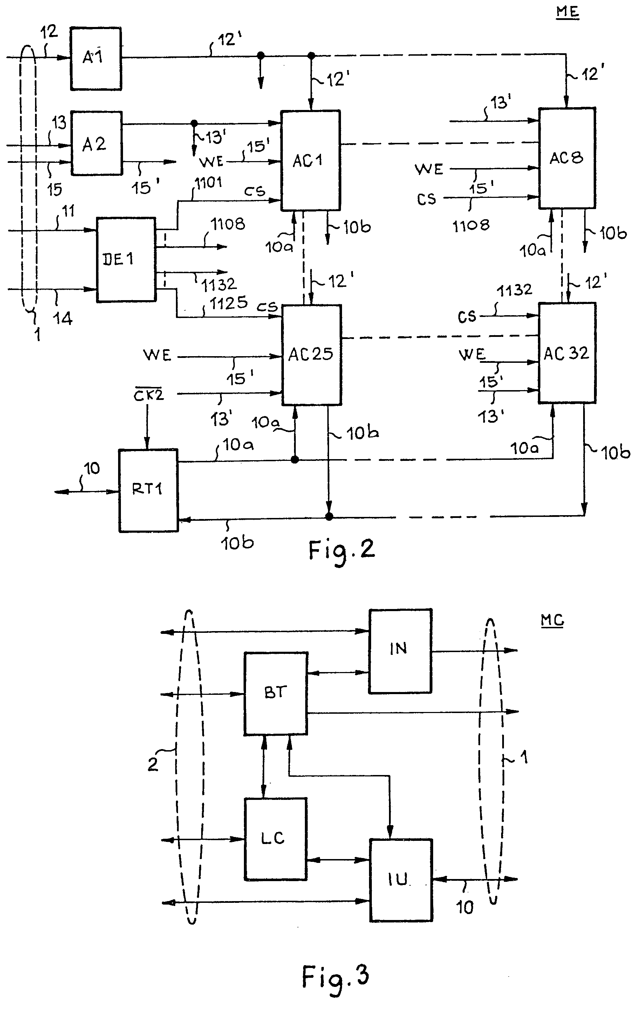

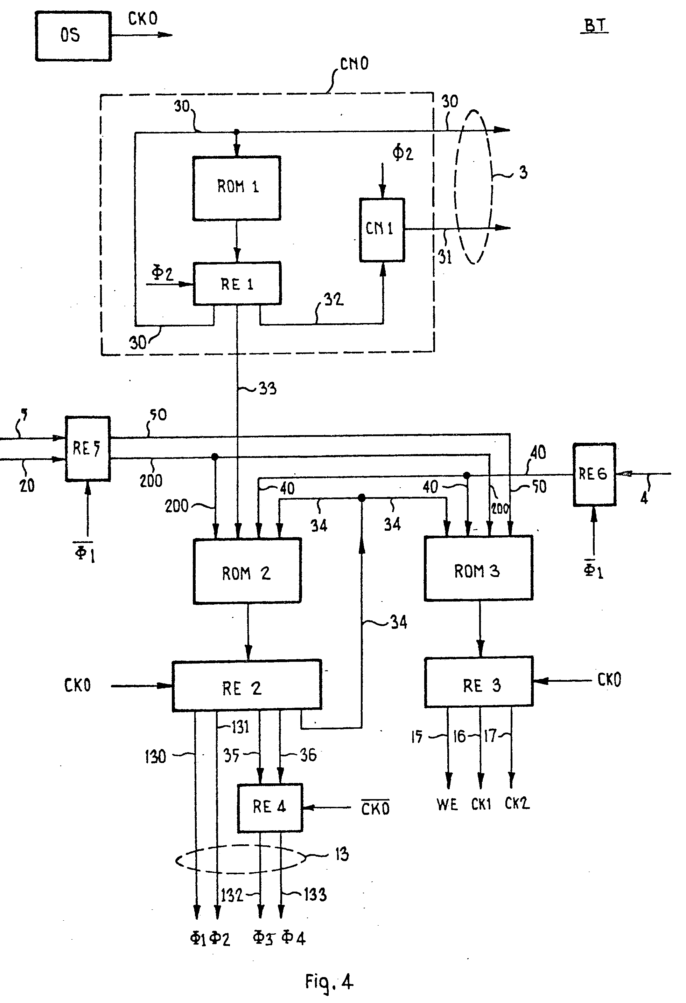

A fault-tolerant memory system is known (IEEE TRANSACTIONS ON COMPUTERS, vol. C-25, no. 6, June 1976, pages 557—568, particularly Figures 2 and 4) comprising in addition to one-bit memory modules spare one-bit memory modules and switching means for switching out failed memory modules and switching in spare memory modules which switching means comprise multiplexers. All memory modules (main modules and spare modules) receive the data through a bus structure, and the switching of the multiplexers is also carried out by the bus control. The bus connection allows the realization of a relatively simple structure, but it has two important drawbacks. The first one concerns the system reliability. The bus represents a reliability node, in that every bus failure makes useless the presence of the spare modules: in fact, due to the bus failure, the switching means cannot receive the switching command. In this respect it is also to be noted that, with a bus structure, some particular module failures cause also the bus failure. The second point concerns the speed of operation, the bus structure being in fact relatively slow. Therefore such system is suitable only when the requirements of speed and reliability are not severe.

Starting out from a solid-state mass-memory as claimed in UK patent application No. 79 08 282, later published under GB—A 2 016 180, the invention aims to provide for higher reliability by offering reconfigurability while at the same time enabling a high speed of operation.

The mass-memory according to the invention is characterized in that the switching means thereof consists of

— a first group of multiplexers which in case of right operation, are able to introduce in the control module the data read in the memory modules of said first group and, in case of failure, to introduce in the control module the data read in the spare memory module or modules, each multiplexer presenting a first input connected to one of the memory modules of said first group, one or more additional inputs, where each is connected to one of said spare modules, and an output connected to one of the transmission lines which, in the absence of faults, convey the bits read in the memory module connected to the first input;

— one or more additional multiplexers, as many as the spare memory modules, able to supply, in case of failure, the data to be written also to the spare memory module or modules, said additional multiplexer or multiplexers presenting a plurality of inputs, where each is connected to one of the transmission lines which convey the data to be written in the memory, and an output connected to the spare memory module or one of the spare memory modules;

— decoding means, able to receive from the controller a code, monitoring which memory module/modules is/are faulty and to generate signals which, in the multiplexer or multiplexers associated with the faulty modules, entail the switching on of one of said additional inputs, said code outgoing from the controller entailing also the setting of the additional multiplexer or of one or more of said additional multiplexers on the input connected to the transmission line associated with the module or one of the modules to be replaced.

Thus, the mass-memory is reconfigurable in that a faulty memory module may be replaced by a spare memory module without any information being lost. Further, the system allows correction of failures in the address decoding and module control.

The mass-memory of the invention does not present any reliability nodes, as all memory modules (main modules and spare modules) are individually connected to the control module for the data transmission, and in the switching points the multiplexers are each connected (from the reliability viewpoint) with a single module: in other words, a failure in a multiplexer for a spare module corresponds to a failure in the spare module, and a failure in a multiplexer for a main module corresponds to a failure in the main module.

Therefore there is no risk of a general failure of the system. A failure in such bus as a bus for the addresses and control signals is handled as a failure in the control module and can be obviated by the structure of claim 4.

The direct connection of the memory modules to the control module allows a high operation speed, therefore the system is well suited to the control of a telecommunications process in which the reliability and the quick operation are important requirements. With reference to the operation speed, the possibility of employing a combinational correction logic (using EX-OR gates) instead of a multiplexer and a flip-flop for this purpose makes it intrinsically faster.

These and other characteristics of the invention will be better disclosed by the following description, given by way of example and in not limiting sense, of preferred embodiments thereof, taken in conjunction with the annexed drawings in which:

Fig. 1 represents the block diagram of a solid-state mass-memory unit consisting also of a memory module with reliability spare functions, and its interconnections with a "multiprocessor" processing system;

Fig. 2 is a block diagram of a single memory module of the memory unit of Fig. 1;

Fig. 3 is a block diagram of the control module of the memory unit of Fig. 1;

Fig. 4 is a detailed scheme of the time base of the control module of Fig. 3;

Fig. 5 is a detailed scheme of the device checking the addresses in the control module of Fig. 3;

Fig. 6 is a detailed scheme of the input/output unit of said control module;

Fig. 6a is the block diagram of the switching point of the input/output unit of Fig. 6;

Fig. 7 is a detailed scheme of the correction logic;

Fig. 8 shows the behaviour of some signals controlling the operations in the memory, under different operating conditions;

Fig. 9 shows schematically a full redundant embodiment of a memory unit.

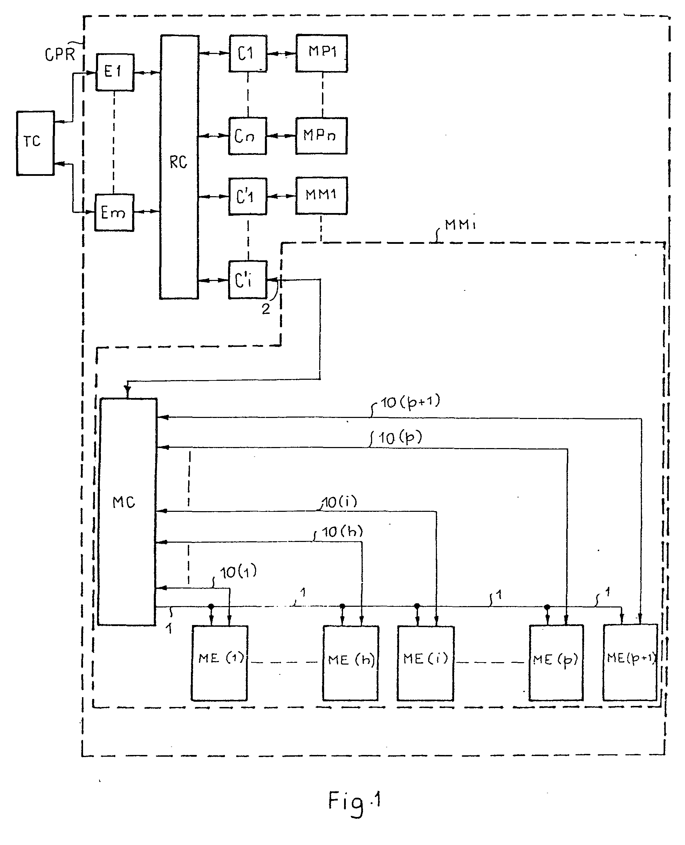

Fig. 1 shows a telecommunications equipment TC, for instance a telephone exchange with stored-program control system CPR, that by way of example and for sake of generality is supposed to be of the "multiprocessor" type.

System CPR comprises: a plurality of processing units E, i.e. E1...Em, one or a plurality of main memory units MP, i.e. MP1...MPn, for on-line data and programs, and one or a plurality of mass-memory units MM, i.e. MM1...MMi.

The presence of several units MM can depend on both memory capacity and reliability purposes, if each unit has not internally a redundant structure.

Processing units E are connected to memory units MM, MP through a connection network RC and so-called "controllers" C and C', i.e. C1...Cn, C'1...C'i, that is the devices controlling data transfer between processing and memory units. Devices C, C', known in the technique, are not an integrating part of the present invention and will not be described in detail.

Every unit MM1...MMi of the mass-memory is composed of a plurality of memory modules ME(1)...ME(p) and at least one spare memory module ME(p+1) as well as of a control module MC.

Memory modules ME are obtained by integrated circuits using a charge-coupled technology; according to the present invention each module stores a bit of all the words storable in the module.

These words are composed of information bits (stored in modules ME(1)...ME(h) and redundancy bits (stored in modules ME(i)...ME(p), that can be used for error-detection and correction.

The number of modules ME of a unit MM is then equal to the number of bits of a word.

As the invention is to be applied to telecommunications systems, for reasons of operating speed, the words ought to contain at least 16 information bits; in addition, it has come out that, using the Hamming code for the error correction, the minimum number of redundancy bits ensuring the single error correction on 16 bits is 5 bits.

Owing to the bit organization according to which each module stores a bit of a plurality of words, the Hamming code allows the detection and correction of all the possible errors occurring in a memory module, as described hereinafter.

The embodiment described refers to words containing, besides the information bits, only the minimum number of redundancy bits, assuring the correction of single errors, in particular it relates to 16-bit information and 5-bit redundancy words.

Then, the memory unit is composed of 21 modules ME(1) to ME(p=21). Nevertheless, a characteristic of the invention is its horizontal flexibility; hereinafter, we examine also embodiments with a higher number of redundancy bits allowing the detection of multiple errors or, above all, the internal reconfiguration of the memory unit, by using one or more modules devoted to redundancy bits: "reconfiguration" means the possibility of substituting a failed memory module with a spare module.

The memory modules are interconnected to each other and to the control module through a bus 1 conveying to all the modules both addresses and control signals; furthermore, each module is connected bidirectionally to the control module through a wire 10(1)....10(p), carrying each information bits.

The structure of modules ME will be described in greater details in Fig. 2.

Control module MC, which is connected to controller C' through a bus 2, has the task of controlling the exchange of data between the controller and the memory, of generating the timing signals necessary to the operation of the memory unit, of providing the correct addressing during the operations, of supervising the operation of the memory itself by detecting and correcting errors and of switching over to memory module ME(p+1) if necessary.

The data transfer between control module MC and controller C' is parallel/asynchronous, i.e. all the bits of a word are transferred parallelly to the control module, at the requested instant.

The independent control of addressing and timing allows the simplification of the structure and programming of the controller; besides, by a suitable choice of the controller, the mass-memory may be seen by the computing system as any main-memory bank. The structure of MC will become clearer from Fig. 3.

With reference to Fig. 2, a generic memory module ME comprises a plurality of integrated charge-coupled circuits AC, identical to one another and designed to store a bit of the words to be stored into unit MM. The choice of the integrated circuit and the number of circuits AC of a module will depend on the required capacity of each module; obviously such a number will depend on construction standards.

By way of example, a module with 32 integrated circuits AC1...AC32 is shown.

Advantageously each integrated circuit AC consists of a plurality of individually addressed blocks of shift registers organized in the serial-parallel-serial configuration, that is each block contains as input register loaded in series and unloaded in parallel, a plurality of intermediate registers loaded and unloaded in parallel, and an output register loaded in parallel, and unloaded in series. By this arrangement the registers of a block actually behave as a single register, and all the blocks form together a random access memory.

In these circuits, beginning from a position indicated by the controller, read, write or "read-modify-write" operations may be effectuated. The last operation occurs when correcting devices have detected an error to be corrected. In the absence of requests for operation, the information will be "refreshed" by recirculating the bits of the information itself.

Inside each block, fast timing signals will control the shifting in series within a register (more particularly the loading of the input register and unloading of the output register); slow timing signals will control the transfer in parallel between adjacent registers (more particularly, the unloading of the input register and loading of the output register).

These signals, hereinafter referred to as "shift signals" and "transfer signals", respectively, have different period and/or shape depending on the type of operation effectuated and on the working phase within each operation, as it will be better described hereinafter. In all the operation phases the ratio between the periods of the two types of signals will obviously remain constant.

A circuit of this type is sold under the name of CCD 464 by the Fairchild Camera and Instrument Corporation of Mountain View (California, USA); this circuit comprises 16 blocks of 128 registers with 32 positions, in which the shifting is controlled by a pair of signals ($\Phi 1$, $\Phi 2$) the first of which determines the time allotted to each bit and the second one controls the actual loading or unloading in series. A second pair of signals, having a period 32 times longer, controls the transfer in parallel.

For clarity reasons, the following description will be made in the assumption that circuits AC are really circuits CCD 464. Yet, by means of obvious modifications, the invention can be applied to any type of charge-coupled memory circuit organized by blocks of registers available in serial-parallel-serial configuration.

A1, A2 denote conventional buffers receiving from the control module MC, through wires 12 which are part of bus 1, the address bits relative to one of the 16 register blocks in all circuits AC and, through wires 13, the shift and transfer signals; A1, A2 amplify these signals so that they can drive all circuits AC.

Buffers A1, A2 are connected to circuits AC through connections 12' and 13', corresponding to inputs 12, 13. A buffer, for example A2, receives from the control module, through a wire 15, also a "write enable" signal WE, conveyed to circuits AC through wire 15'.

DE1 denotes a conventional decoder, receiving from the control module, through a connection 11, the most significant address bits (i.e. the bits detecting one of the 32 circuits AC); the output of DE1 is a signal CS enabling the real addressing of one of circuits AC1...AC32.

Signal CS is sent to the relevant circuit through one of wires 1101...1132.

The decoder receives also from the control module MC, through a wire 14, an enable signal for the whole module.

RT1 denotes a receiving/transmitting unit acting as data input/output unit, connected to the control module through wire 10 and to memory circuits AC through wires 10a, 10b, conveying the bit to be written and the read bit, respectively.

The operation of the transmitter of RT1 is enabled by a signal coming from the control module (signal CK2), as described hereinafter.

With reference to Fig. 3, control module MC comprises a time base BT, an address control device IN, a data input and output unit IU and a self-correcting logic LC.

The microprogrammed time base BT is designed to generate timing signals for memory unit MM (Fig. 1), enclosing the shift and transfer signals, and to generate together with IN read and write addresses in circuits AC (Fig. 2) of each module ME (Fig. 1). The microprogrammed structure operates so that certain operations occur at a variable speed depending on the operating phases.

Input/output unit IU has the task of controlling the operations connected with the asynchronous data exchange between the controller and the memory and viceversa.

Self-correcting logic LC is designed to generate redundancy bits, on the basis of the information bits received through IU; in case of memory reading, LC is also entitled to compare the generated bits with the read bits; in case of discrepancy, to correct the information bits and to signal the discrepancy to the controller; and in case of one of the memory modules failing, to provide to switching over to the spare memory module.

The structure of blocks IN, BI, IU, LC and the interconnections between said blocks will result in greater details in the following Figures. To simplify the drawing, Figure 3 schematizes with separated connections the links of each block with the controller, the memory modules or the remaining blocks.

With reference to Fig. 4, OS denotes a conventional oscillator, which generates a fundamental clock signal CKO utilized by the time base to obtain other timing signals.

References ROM1, RE1, CN1 denote a read-only-memory, a parallel-parallel register and a counter that together form a counter CNO module 4096 acting as an address counter. More particularly, the result of the counting of CNO detects the position of a word inside a block of registers in circuits AC (Fig. 2) of the different modules as an effect of the shift and transfer signals: at the output 31 of CNO the least significant bits of the complete address will be present.

Counter CNO is subdivided into two counters module 64, one of which, with output decoding, consists of ROM1 and RE1 and the other one of CN1.

Memory ROM1, which is addressed by the counting of its internal state, contains 64 words, each comprising six bits of internal state (that is six bits indicating the result of the counting module 64), three bits forming a conditioning signal for a second read-only memory ROM2, and 1 bit forming the carry of the counter.

The words of ROM1 are stored and recalled in parallel by RE1 upon command of the shift signal ($\Phi2$) which causes the store and recall of the bits of the memory: thus RE1 stores a new word each time that a bit must be shifted by a position inside the input or output register of a block of circuits AC (Fig. 2).

The output of RE1 relative to the state bits (wires 30 of connection 3) is carried to ROM1 as address signal; wires 30, together with wires 31 outgoing from CN1 transfer to device IN (Fig. 3) the sequential part of the address, to be compared with the same address part generated in IN.

The output 32 (Fig. 4) relative to the carry, forms an input of counter CN1 and advances it by a step at each complete reading of ROM1.

The result of the counting effectuated by CN1, which originates the most significant bits of the sequential part of the address, is presented to output 31 upon a command of the same signal $\Phi2$ controlling the storage of bits into RE1. In this way all the bits of the sequential part of the address are present at the same time.

A further output 33 of ROM1 transfers to ROM2 three decoding bits of the internal state of ROM1, used for generating transfer signals.

Memory ROM2 forms, with a second parallel-parallel register RE2, a sequential logic with 8 internal states identifying the elementary time inside a cycle, and is designed to generate shift and transfer signals. Memory ROM2 contains 512 words, each comprising three status bits and four bits relative to each one of said signals, and is jointly addressed by its internal state, the decoding bits of the internal state of ROM1, two bits denoting what type of operation is in progress, and the result of the comparison between the sequential part of address generated by CNO and the one generated by IN (Fig. 3).

The signals denoting the type of operation arrive from the controller through wires 20, register RE5 and wires 200; the comparison signal arrives from IN through wire 4, register RE6 and wire 40.

Registers RE5, RE6 can transfer to the output the signals present at their inputs in correspondence with the trailing edge of $\Phi1$ (denoted by $\overline{\Phi1}$).

The words of ROM2 are stored (and recalled) by RE2 at a rhythm similar to the one of fundamental clock CKO. The outputs of RE2 relative to the internal state of ROM2 (wires 34) are used as addressing signals for the memory itself and for a further read-only memory ROM3; the outputs relative to shift signals $\Phi1$, $\Phi2$ (wires 139, 131) are sent to memory circuits AC; the transfer signals present on output wires 35, 36 are stored into a register RE4 designed to determine the exact phase location of the transfer signals with respect to the shift signals. The storage onto RE4 is controlled by the trailing edge of the pulses of CKO (signal $\overline{CKO}$) whilst RE2 is controlled by the leading edge of the same pulses.

Effective transfer signals $\Phi3$, $\Phi4$ are present on output wires 132, 133 of RE4 (which with wires 130, 131 form connection 13).

The use of read-only memories allows the required variability of both period and shape of said signals to be easily obtained as a function of the type of operation and operating phase in each operation.

More particularly, at each read and/or write operation, a fast shift of bits in register blocks can be controlled till the required initial word is reached; after this phase a slower shift will occur (for instance with a double period) for the real transfer of words to the memory or computer. In this way a reduced access time is obtained, whilst the read and/or write mode occur at a slower rhythm in order to take into account the processor requirements.

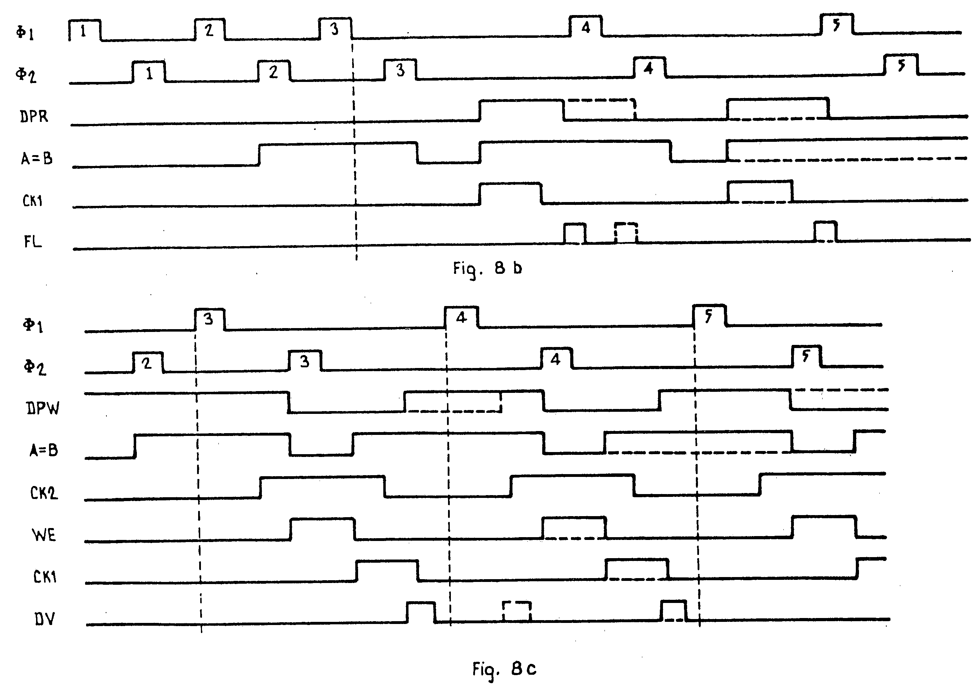

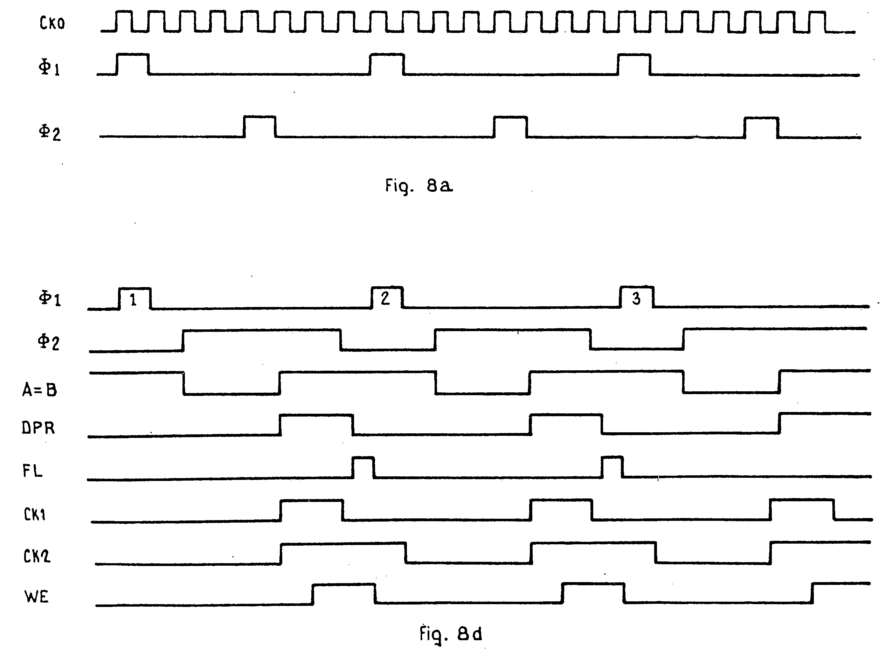

As to the shape of the shift and transfer signals, the address of memory ROM2 conditioned by the kind of operation will of course allow at the output a sequence of words such that the bits relative to each one of said signals may remain in either of logic states as long as required. This will be clearly seen by examining Fig. 8.

Read-only memory ROM3 is a combinatory logic, that in function of the kind of operation (present on wires 200) of the internal state of memory ROM2 (arriving to ROM3 through wires 34), of the comparison signal coming from IN (Fig. 3) through wires 4, 40 and of two signals denoting the data transfer status (signals coming from input/output unit IU, Fig. 3, through wires 5, register RE5 and wires 50), generates the timing signals different from shift and transfer signals.

ROM3 contains 256 words, each one of them comprising the bit originating enabling to write signal WE, and two bits (CK1, CK2) the first of which enables the data transfer towards the controller and the generation of the sequential part of address by means of IN, and the second one enables the data transmission to memory modules. In the absence of CK2, data transmission will be enabled by memory modules towards controller. It is worth noting that bit CK1 can be emitted only if the signals present on wires 50 denote the end of an operation and whether address identity between IN and CNO occurs for this cycle.

It has to be remembered that registers RE5, RE6 load the bits present at their inputs in correspondence with the trailing edge of $\Phi1$. In this way, practically at the beginning of a memory cycle, the memory knows whether it has to effectuate an operation or it does not, whether it must set itself in search phase or whether it must really read or write data.

A parallel-parallel register RE3 timed by CKO provides the correct positioning in time of the signals generated by ROM3 before transferring them to utilization devices through wires 15, 16, 17. Also the shape of WE, CK1, CK2 will be seen with reference to Fig. 8.

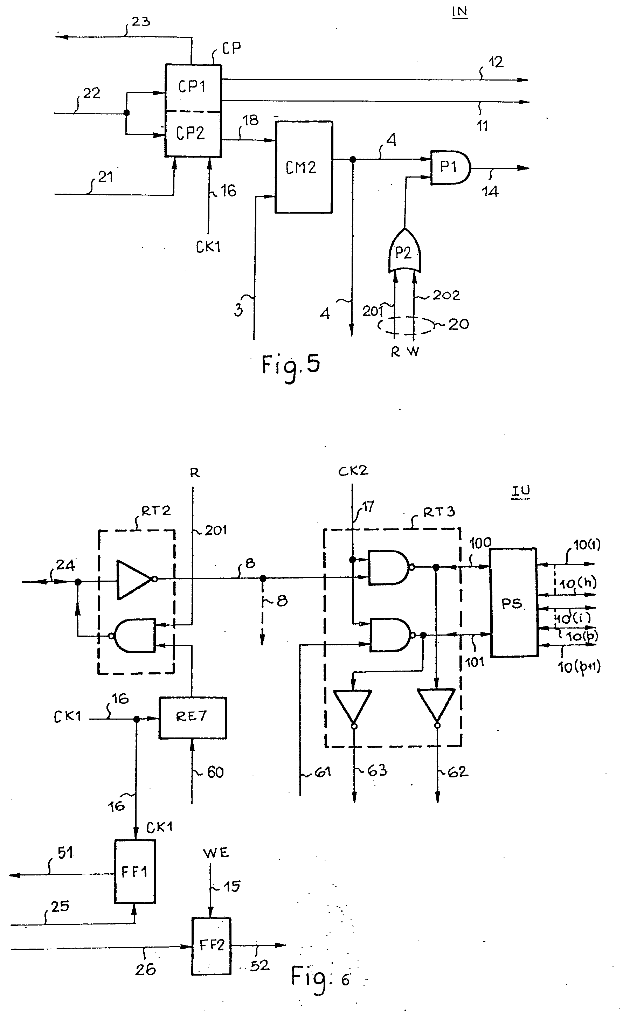

In Fig. 5, CP denotes a presettable counter, with a pair of inputs, connected to the controller through connection 22 and wire 21, presenting the address of the first word involved in an operation and the loading command for such address, respectively. Beginning from such an address, CP generates sequentially the addresses of all the words involved in the operation, and increases its contents at the end of each read and/or write operation. The advance command is provided by signal CK1 whose generation, as stated, depends on the ending of a preceding operation.

CP can be considered as subdivided into two parts, CP1, CP2 which receive respectively the most significant bits of an address (that is the bits identifying the integrated circuit interested in an operation, in each module and the block of shift registers in said circuit) and the least significant bits of the same address (that is the bits identifying the word inside a block).

Counter CP1 is connected to decoder DE1 (Fig. 2) and amplifier A1 of the memory modules through wires 11, 12 respectively, on which the part of the address relative to integrated circuit and block of registers is present.

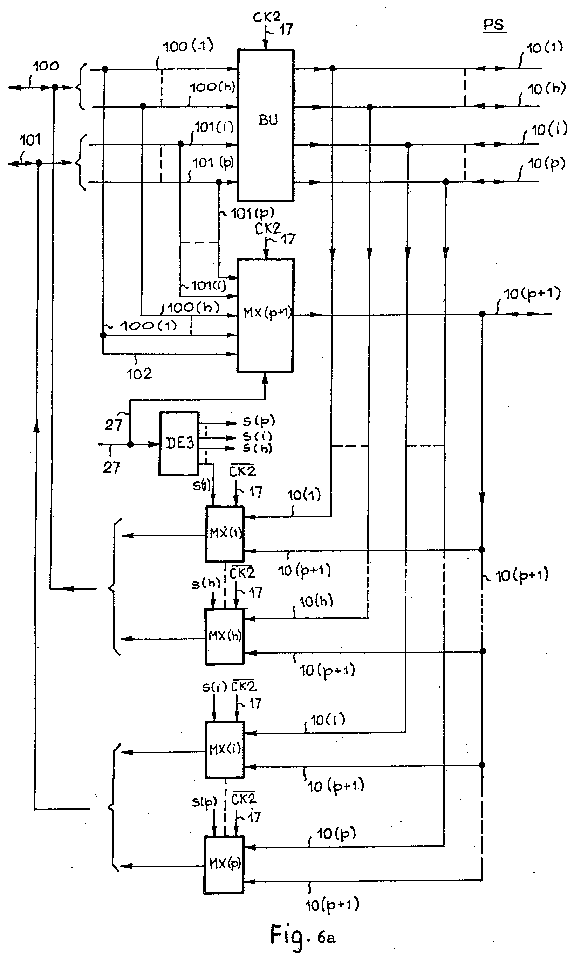

Counter CP2 is connected to an input of a comparator CM2 (Fig. 6) through wires 18 on which the sequential part of the address is present.

CM2 has a second input connected to connection 3 through which it receives the sequential part of the address generated by the time base.

Wires 18 and the wires of connection 3 will be connected to the inputs of CM2 so as to optimize the access time to memory taking into account the speed of the controller, as explained later.

In case of equality of the addresses, CM2 generates the comparison signal that through connection 4 is sent to both the time base and the input of a two-input AND gate P1.

The other input of gate P1 is connected to the output of a two-input logic OR gate P2, which receives from the controller, through wires 201, 202 of connection 20, the signals R, W indicating the request for a reading or writing respectively, in the memory. The output of gate P1 is connected through wire 14 to decoder DE1 (Fig. 2), enabling it to operate.

In Fig. 6, reference RT2 denotes a conventional data transceiver, for instance of the type "open collector". To simplify the drawing an only logic gate for each direction has been shown, but it is evident that RT2 consists of as many pairs of gates as are the wires of connection 24.

In case of data transfer from the controller towards the memory, RT2 receives from C' (Fig.

1) through wires 24 (Fig. 6), the 16 information bits and transfers them via bus 8 towards a second transceiver RT3 and hence on wires 100, to be switched to wires 10(1)...10(h).

In case of data transfer towards the controller, RT2 sends on wires 24 the information bits, possibly corrected by logic LC (Fig. 3) and received through wires 60 and a register RE7 timed by signal CK1; during read-modify-write mode, the same corrected bits may also be transferred to RT3, thus allowing the correction of memory without controller intervention.

The transmission towards the controller is enabled when wire 201 presents the signal indicating that a read phase is in progress.

Transceiver RT3 consists of two units, each as RT2. In case of writing in memory, RT3 transmits on bus 100 the information bits coming from RT2 and on wires 101 (to be switched to wires 10(i)...10(p)) the redundancy bits coming from correction logic LC (Fig. 3) through wires 61 (Fig. 6). The transmission is enabled by signal CK2 present on wire 17.

In case of reading in memory, RT3 transfers towards correction logic LC (Fig. 3) both the information (wires 62) and redundancy bits (wires 63) so that LC may effectuate check and correction operations.

FF1 denotes a conventional flip-flop controlling the "hand shaking" in reading, between the memory and the controller, that is the dialogue necessary to the correct transfer of the data read in the memory.

Whenever FF1 receives from the time base, through wire 16, a pulse of signal CK1, FF1 emits on wire 51 towards the controller a signal indicating that a datum read in the memory is ready to be transferred to the controller and hence that a reading is in progress; the signal is also sent to memory ROM3 (Fig. 4) of BT.

FF1 is reset to zero when a signal, confirming the occurred data acceptation, arrives from the controller through wire 25 (Fig. 6).

Reference FF2 denotes a second flip-flop, identical to FF1, designed to control the "handshaking" in writing between the memory and the controller, that is the dialogue necessary to the correct transfer to the memory of the data supplied by the processor.

Whenever FF2 receives from controller C' (Fig. 1), through wire 26, a signal indicating that the datum is valid, i.e. that it must be really written, FF2 emits on its output 52 a signal indicating that a datum coming from the processor is ready to be transferred to the memory.

In addition, FF2 is reset to zero by the trailing edge of enabling-to-write signal WE, coming from the time base through wire 15.

The signal present on wire 52 (which with wire 51 forms connection 5 of Fig. 4) is sent to both memory ROM3 of the time base as "ready datum" and the controller, which thus is informed if the operation is still in progress or is completed.

The addition of module ME(p+1) (Fig. 1) implies that module MC, and in particular input-output unit IU, contains "switching points", that is the circuits that in case of a failed memory module allow the sending of the bits intended for the damaged module to the spare module and to the controller of the bits coming from the spare module instead of those of the failed module.

These switching points are provided for by a circuit PS in Fig. 6 and are connected on one side to buses of wires 100, 101 and on the other side to the memory modules through the wires 10(1)...10(h), 10(i)...10(p), 10(p+1).

An embodiment of circuit PS is shown in Fig. 6a. In this Figure MX(1)...MX(h), MX(i)...MX(p), MX(p+1) denote conventional multiplexers with tri-state output; BU a set of tri-state or open collector buffers, enabled by signal CK2, connected on one side to wires 100, 101 and on the other to wires 10 and carrying out functions similar to those of transmitters RT2, RT3 (Fig. 6).

The term "tri-state" means, as known to technicians, that, besides the two usual logic levels, a third state with high impedance output is possible. This allows the use of bidirectional transmission lines for the connection between control module and memory modules.

Each multiplexer MX(1)...MX(p) presents two inputs and an output: the first input of each multiplexer is connected to the memory module with the same index, through respective wire 10, the second input of all the multiplexers is connected to spare module ME(p+1) through wire 10(p+1).

Multiplexers MX(1)...MX(p), which are enabled during memory reading (absence of signal CK2), are normally set on their first input.

The possible switching on the second input, in case of failure or conditions described hereinafter, is controlled by a respective select signals s(1)...s(h), s(i)...s(p) coming from a decoder DE3 receiving and decoding a bit configuration sent by the controller through a connection 27 and indicating which memory module should be replaced by the spare module. Therefore, this bit configuration acts as a switching command.

Multiplexer MX(p+1) is provided with an output connected to spare module ME(p+1) through wire 10(p+1) and p inputs connected to wires 100(1)...100(h), 101(i)...101(p), respectively. MX(p+1) is provided with an additional input, connected to a wire 102; as advantage this input can be steadily connected in parallel to one of the other p inputs, e.g. to input 100(1), and it is connected to output 10(p+1) under usual operation conditions of the memory.

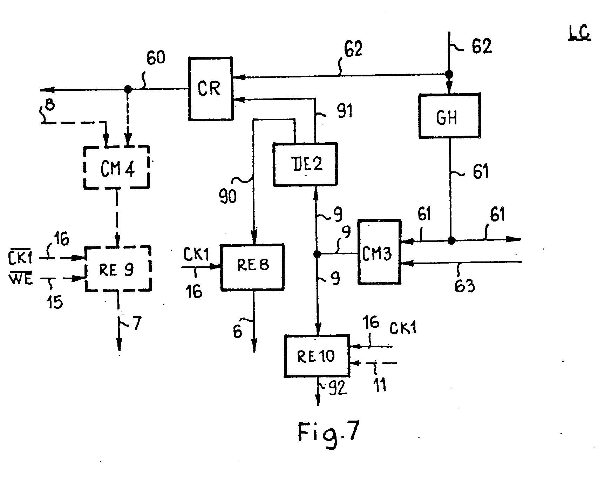

Fig. 7 represents by way of example a correction logic based on the Hamming code and using five redundancy bits, which allows the correction of single errors on words presenting at most 31 bits, considering also the redundancy bits. The description refers to the considered example, i.e. words with 16 information bits. In the drawing, reference GH denotes the generator of such redundancy bits, that advantageously consists of a set of 5 parity generators to which the sixteen wires 62 are duly connected.

Output 61 of GH is connected on one side to RT2 (Fig. 6) and on the other to an input of a comparator CM3 consisting for instance of exclusive-OR circuits; a second input of CM3 is connected to wires 63 conveying the redundancy bits read in the memory.

Output 9 of CM3 presents five bits that with their logic value denote whether the bits present on wires 61 and 63 are equal or not. These five bits constitute an error code indicating the incorrect information bit; taking into account that the memory is organized by bits and that a bit of a word for each module is stored, the error code indicates also the failed module.

Output 9 of CM3 is connected on one side to a register RE10, timed by CK1, whose output 92 is connected to the controller and conveys the information relative to the failed module.

On the other side output 9 of CM3 is connected to an input of a decoder DE which on the basis of the bits of the error code provides on output wires 91 sixteen bits whose logic value indicates the possible error of a corresponding information bit. Wires 91 are connected to an input of a correcting device CR, advantageously consisting of exclusive-OR circuits, whose second input is connected to wires 62. The output of CR is composed of wires 60 on which the corrected bits are present.

As the memory is organized by bits, any failure of the module (memory integrated circuits or addressing unit) gives rise to an error in the unique output bit of the module; therefore, when CR corrects that bit, it corrects also any error of the module (self-correction with high coverage).

A further output 90 of DE2 carries the information on the presence or absence of errors, and is connected to a register RE8 timed by CK1. The output of RE8 is connected to the controller through a wire 6.

The structure just described is sufficient to detect and to correct the memory errors. For detecting possible malfunctions of logic LC and unit IU (Fig. 3), logic LC can comprise a further comparator CM4 (Fig. 7), having an input connected to the output of CR and another one to bus 8. Then CM4 compares the bits corrected by LC to those present on bus 8 after correction. The output of CM4 is connected to a register RE9 activated by the trailing edge of $\overline{CK1}$ (denoted by $\overline{CK1}$) or of WE (denoted by $\overline{WE}$); the output of RE9 (wire 7) is connected to the controller.

A further performance of correction logic LC is to store in RE10 not only the error code present on wires 9 and indicating the incorrect bit of a word, but also the address part present on wires 11: this allows the detection of the memory circuit that originated the error and the sending of the relative information to the controller.

Obviously, by utilizing a greater number of redundancy bits and/or a code different from the Hamming code, multiple errors can be detected and connected.

The mode of operation of logic LC is as follows.

First considering a reading in the memory, the information bits coming from a memory module on wires 100 (Fig. 6) are sent through wires 62 to generator GH (Fig. 7), whilst the redundancy bits present on wires 101 are sent through wires 63 to CM3, that that compares them to those present on wires 61. (It is to be noted that in read phase the transmitters of RT3, Fig. 6, are disabled, thus the bits present on wires 61 cannot come back to wires 101). Possible errors, recognized as discrepancies between the corresponding bits on the two inputs, are indicated by the presence of one or more $O$ s on wires 9.

The signals present on wires 9 are sent to DE2 that, on the basis of the location of $O$ s in the output configuration of CM3, identifies the information bits resulting incorrect and emits on wires 91 sixteen bits, each one associated to an information bit. In the presence of an incorrect bit, the corresponding bit will have a logic value such as to cause in CR the inversion of the logic value of said incorrect bit and then its correction.

The corrected bits are then sent to the transmitter of RT2 (Fig. 6) and hence to the controller. In case of read-modify-write mode of operation, as also the transmitters of RT3 are enabled, the corrected bits presented by RT2 on bus 8, can be transferred on wires 100 and then sent to the memory.

In case of presence of comparator CM4 (Fig. 7), the corrected bits present on wire 60 are compared to those arrived at RT2 (Fig. 6) through RE7 and presented on bus 8; in this way the good operation of RT2 and bus 8 is verified. The result of the comparison is sent, as stated, to the controller.

During writing, the information bits coming from the controller still arrive at GH (Fig. 7) through RT2 (Fig. 6), bus 8, RT3 and wires 62, and the redundancy bits generated in GH are sent to the memory via wires 61. As the transmitters of RT2 are disabled, the bits present on wires 60 cannot be transferred to the controller.

If comparator CM4 is present, the bits on wires 60 can be compared to those really transmitted by the controller and present on bus 8; a possible discrepancy will point out possible failures in LC; the anomalous situation will be put into evidence to the controller through register RE9.

Figures 8a, 8b, 8c, 8d show the behaviour of some of timing or conditioning signals in the various modes of operation of the memory, such as: refresh, read, write, read-modify-write.

The signals that in a certain operation are always at $O$ have not been represented for said operation.

As to the output signals from BT, transfer signals have not been represented as they are not functional for the description of the mode of operation.

Shift signal $\Phi1$ presents a pulse that has always the minimum possible duration permitted by the fundamental clock signal (one period of CKO) and always appears at the beginning of the period of signal $\Phi1$ that, as already said, defines the time available in the memory for each bit (cycle).

Signal $\Phi2$ presents a pulse delayed with respect to pulse $\Phi1$ to an extent dependent on the kind of operation, and has the minimal duration with the exception of the read-modify-write operation, where two operations are necessary for the same memory cell.

As to the other signals emitted by BT, WE is obviously active only during the operation phases establishing memory writing and it presents a pulse with constant deviation but variable position; signal CK1 is active during write, read, read-modify-write modes and presents in all these cases a pulse of constant duration and position; signal CK2 is active in the same cases as WE and presents a constant duration pulse such that it overlaps the pulse of WE, whatever its position may be.

In addition, references DPR, DPW of Fig. 8 denote the signals of "ready datum" in reading and writing present on wires 51, 52 (Fig. 6) which denote, by passing to $O$, the completion of an operation; reference A=B denotes the signal whose logic level $1$ characterizes the equality between sequential addresses generated by CNO (Fig. 4) and CP (Fig. 5); reference FL denotes the signal of the reading end coming from the controller on wire 25 (Fig. 6); reference DV denotes the signal coming from the controller on wire 26 and indicating that a datum to be written is valid.

It will be noted that signal CKO is represented only for the refresh mode.

The mode of operation of the device according to the invention will now be described separately for the some types of possible operations, that is: information refresh, read, write, read-modify-write modes, writing in the spare module data from a module to be substituted.

For this description reference will be made also to the diagrams of Fig. 8, supposing, by way of example, that fundamental clock signal CKO has a period of 100 ns, and that shift signals $\Phi1$, $\Phi2$ have a period of 400 ns in case of fast shift and of 800 ns in case of slow shift.

1) Refresh mode

This phase is controlled by the time base when the memory is not used, that is nor reading or writing is required by controller C' (Fig. 1).

Under these conditions there is no output signal from gate P1 of IN (Fig. 5), thus all memory circuits AC (Fig. 2) are disabled by decoder DE1. In addition also signals WE, CK1, CK2 are at 0, so that transceivers RT1 (Fig. 2), RT2, RT3 (Fig. 6) are not enabled and no bit loading or unloading is possible in circuits AC.

Hence these circuits receive from the control module only the shift and transfer signals, that on this occasion have maximum period.

Under these conditions the bits stored in the registers are recirculated continuously, thus allowing the information keeping.

2) Read mode

A read operation can be considered as formed of two phases: data search and transfer.

The first phase begins when controller C' (Fig. 1) activates the reading signal (wire 20, Fig. 4) possibly signalling to address control device IN (Fig. 3) the address of the first word involved in the operation, and ends when the time base generates the address where said word is stored; the second phase begins at that instant and terminates when the transfer is over.

Of course there will be no search phase if the initial address signalled by the controller is the one on which the memory is located.

The following description is referred to the most general case in which the read operation comprises both phases.

This being stated, when the controller requests the reading, it can send to CP (Fig. 5) both the initial address and command for storing such an address, and to P2, ROM2 (Fig. 4) and RT2 (Fig. 6) the indication that a read operation is requested (signal R at 1 on wire 201).

Under this assumption, the address supplied by CP (Fig. 5) is different from the one of CNO (Fig. 4); the output signal of CM2 (Fig. 5) signals this situation to ROM2 and ROM3 (signal A=B at 0, Fig. 8b) which put themselves in search phase and generate signals $\Phi1$ to $\Phi4$, and CK1 with a period and shape typical of this phase. More particularly, $\Phi1$, $\Phi2$ have the minimum period and CK1 is at 0 (Fig. 8b).

These conditions are valid till the cyclical counting of CNO (Fig. 4) generates, as next state of ROM1, the same address denoted by CP (Fig. 5). This condition is supposed in coincidence with the second pulse of $\Phi2$ in Fig. 8b. At the end of the subsequent pulse of $\Phi1$ (pulse 3), memories ROM2, ROM3 find address coincidence (signal A=B at 1), no operation in progress (signal DPR at 0) and a reading request: consequently, they locate themselves in a state corresponding to the actual read phase, i.e. $\Phi1$, $\Phi2$ recover a maximum period and the pulse of CK1 can be emitted.

As the reading signal is always present on wire 201, transmitter RT2 (Fig. 6) and gate P1 (Fig. 5) are enabled to let through the signals present at their inputs, whilst the transmitters of RT2 (Fig. 2) are enabled, as CK2 is at 0.

Furthermore, the passage to 1 of signal A=B present on wire 14 (Figs. 2, 5) enables decoder DE1 of all memory modules, that decodes the address bits present on wire 11 and then enables one of the 32 circuits AC, e.g. AC1, in all modules ME.

At the subsequent passage to 1 of $\Phi2$ (pulse 3, Figure 8b) the output registers of a same block of circuits AC1 of all the modules present at the output the bit stored in their last cell.

In each module, the bit read in circuit AC1 is sent through wire 10b to the transmitter of RT1 that sends it on the respective wire 10; the bits present on all wires 10 of the memory unit represent the word read in the memory and sent to the control module, where they reach the transceiver RT3 (Fig. 6) through the multiplexers MX(1)...MX(p) (Fig. 6a) set on their first input.

In particular the bits read in the memory are transferred to correction logic LC (Figures 3, 7) for check and possible correction.

Corrected bits and error signalling, present on wires 60 and on wire 90 respectively, arrive at the input of registers RE7 (Fig. 6) and RE8 (Fig. 7) and, as soon as CK1 passes to value 1, they are presented on wires 220 and 6, respectively. Meanwhile, at the end of pulse 3 of $\Phi2$, counter CNO (Fig. 4) is advanced by one step, thus it marks an address different from CP (Fig. 5).

When CK1 passes to 1 (Fig. 8b), also counter CP (Fig. 5) advances by one step, thus the addresses are equal again (supposing the comparison occurs between bits of the same weight); besides, DPR (Fig. 8b) passes to 1 and there remains till signal of end of reading FL arrives to FF1 (Fig. 6).

If such a signal arrives before the end of the subsequent pulse of $\Phi1$ (pulse 4), that is if the controller has stored the data within the 400 ns elapsed between the passage to 1 to CK1 and the passage to 0 of $\Phi1$, the same situation present at the end of pulse 3 occurs and then the operations are repeated as in the previous cycle for the next word to be read.

Then this procedure goes on unchanged till the controller takes away the read command either because the whole block of words has been read or because CP (Fig. 5) has signalled the end of its counting capacity.

Then the system comes back to the conditions already described for the information "refresh".

In case controller C' was unable to store the first word within the predicted time, at the end of pulse 4 of $\Phi1$, signal FL has not yet arrived, and so DPR is still at 1, as denoted by the broken line in Fig. 8b. In this situation the emission of CK1 is not enabled, thus at the arrival of pulse 4 of $\Phi2$, when the time base advances again by one step, address discrepancy between CNO (Fig. 4) and CP (Fig. 5) will occur. The time base restores itself in search phase till the address identity is found again.

The passage to a search phase can occur either when the signal of reading end arrives, or as soon as the address discrepancy is found. It is evident that in case of very slow control systems requesting some periods of Φ1 to store a word, the second solution can allow the operations to be sped up.

It has to be remembered that, owing to the structure of the memory, the period of Φ1 cannot be lengthened beyond a certain limit, because it may happen that the control system is unable to store the data within the available time.

It is clear, however, that the data do not get lost because a new operation cannot begin if the previous one is not completed (CK1 is at $O$ if DPR is not at $O$ before the end of the pulse of Φ1).

Under the conditions described above (that is controller unable to accept the data within a period of Φ1) the next address equality can occur only after a time depending on the way the inputs of CM2 (Fig. 5) have been connected to wires 3 and 18. If the connection is such that the bits with equal weight are compared in the two addresses, reading will be possible only after that the time base has scanned again the addresses of the 4096 cells of a block. If, on the contrary, the wires are connected so as to compare the bits with different weight in the two addresses, a more frequent reading is possible. For instance, if the controller requires a reading time comprised between 1 and 2 cycles, the least significant bit of the time base can be compared to the most significant one of the word counter; the second bit of the time base can be compared to the least significant one of the counter of words, the third bit of the time base can be compared to the second bit of the counter and so on; in this way there is address equality every two cycles and so the optimization of transfer speed. Analogous procedure can be followed in cases where the controller requires for instance 4, 8...cycles for reading; then it will be enough to shift the wires by two, three positions.

3) Write mode

The write operations are basically carried out by following the same procedures adopted for read operations, that is when the write command arrives from C' (Fig. 1), the search of the first address begins, and then the actual data transfer. The search phase is identical to the read phase, with the only exception that the enabling signal for gate P1 (Fig. 5) of IN arrives through wire 202 and not wire 201. When the addresses have been established equal (for instance again during the second cycle of Φ1), at the end of the subsequent pulse of Φ1, DPW is at $1$ (supposing the controller has furnished the first character to be written at the moment of the writing request), signal A=B is at $1$ and obviously the signal of writing request (not shown) is at $1$. Under these conditions, ROM2, ROM3 dispose themselves in the state corresponding to writing, wherein, as stated, WE and CK2 will be active and the pulse of Φ2 is slightly more delayed with respect to the one of Φ1 than it happened during reading (for instance 200 ns instead of 100) in order to allow a better matching of the operation in the cycle.

At the passage to $1$ of CK2, transmitter RT3 (Fig. 6) is enabled to let through the bits present on bus 8 and to transfer them on wires 100 through buffer BU (Fig. 6a) and wires 10(1) to 10(h) towards transceiver RT1 (Fig. 2) of the memory modules ME1...MEh; in each module, the arrived bit is presented on wire 10a. If multiplexer MX(p+1) is provided with a "rest" input connected as input 102, the data concerning for example module ME(1) are written also in spare module ME(p+1). From wires 100 (Fig. 6) the information bits are transferred also through wires 62 to the correction logic that generates redundancy bits and transmits them to RT3 that in turn presents them on wires 101 (Fig. 6) and sends them via the wires 10(i) to 10(p) to memory modules ME1...MEp. The next passage to $1$ of WE and of Φ2 enables in each memory module the input registers of circuit AC (Fig. 2) enabled by DE1 to store actually the bit arriving on wire 10a and in addition advances CNO (Fig. 4) by one step.

At the passage to $1$ of WE, signal DPW is put to $O$ so that the controller may be ready for the subsequent operation. In addition, if logic LC (Fig. 3) comprises comparator CM4 (Fig. 7) and register RE8, the possible presence of malfunctions in the transceivers and bus of IU or logic itself is signalled to the controller.

At the passage to $O$ of WE, signal CK1 passes to $1$, thus advancing by one step counter CP (Fig. 5): address equality is again reached. If, before the end of the cycle, the new signal of valid datum DV (Fig. 8c) that restores to $1$ signal DPW, arrives from the controller, the conditions necessary to writing are again reached; writing will take place during the subsequent cycle following the same procedure.

If the signal of valid datum does not arrive before the beginning of the cycle during which the write operation is to be carried out (for instance with reference to Fig. 8c, before the beginning of the cycle identified by pulse 4 of Φ1), at the arrival of such a pulse, DPW would be at $O$. Under these conditions (denoted by a broken line in Fig. 8c), signal WE remains at $O$ so that the operation is not carried out; as a consequence CK1 remains at $O$, CP (Fig. 5) is not advanced, and at the subsequent cycle the addresses generated by CNO (Fig. 4) and CP (Fig. 5) (supposing the comparison occurs between bits with equal weight) will not be equal, thus preventing again operations from being carried out. Also in this case, the above mentioned considerations related to read operations for connecting the wires of connections 3 and 18 (Fig. 5) with the inputs of CM2, remain valid.

Obviously, if DV does not arrive even if delayed, the memory enters the refresh state. Such situation is not represented in Fig. 8c.

4) Read-modify-write mode

This type of operation allows the rewriting in the memory of the data corrected in the correction logic; the relative information is supplied to the time base by the simultaneous presence of signals R, W.

In this type of operation $\Phi 1$, $\Phi 2$ are at maximum period (Fig. 8d); $\Phi 2$ passes to 1 as for the reading but it remains at 1 till about the end of the cycle (for instance 100 ns before the end). In this way the memory is preset to carry out two operations for the same cell. Signal CK1 has still the same behaviour as described for read and write modes.

Signal WE passes to 1 short after CK1 (for instance after 100 ns) and remains at 1 till the end of the cycle. Signal CK2 will be superimposed on WE as for writing and passes to 1 with CK1, coming back to 0 at the end of pulse $\Phi 1$ of the subsequent cycle.

In this kind of operation, while $\Phi 2$ is at 1, both signals CK1 and WE (and then CK2) are at 1 for a certain time; consequently the data can be transferred to both the controller and the memory; more particularly, the corrected data supplied by the correction logic through wires 60 are presented by RE7 on both wires 220 and bus 8 (as in read mode) and in addition can pass from such a bus onto wires 100 and 61 (as in write mode) and can be sent to both ME and the correction logic in order to generate redundancy bits.

In this type of operation, as shown in Fig. 8d, the dialogue on the controller side appears to be slaved only to the ready datum in reading (DPR) and to the end of reading signal FL, whilst signals DPW and DV are disregarded and hence not represented.

Obviously the considerations already applied for reading and writing may be applied, also to said case, if the controller is slow with respect to the memory.

The embodiment described relates to the case of words containing, besides the information bits, only the minimum number of redundancy bits necessary for self-correction. Nevertheless, the bit organization of the memory allows a certain flexibility in the number of both information and redundancy bits.

The variation of number h of information bits involves only the changement in the number of both memory modules ME (Fig. 1) intended for said bits and connection wires 100 (Fig. 6). This happens where the number of information bits added to the number of redundancy bits is lower than the number of bits checkable by the established redundancy bits (in our case, five redundancy bits can control 31 bits, then the information bits can increase up to 26 without involving an increase in the redundancy bits). Obviously, the number of information bits can exceed said value involving also the increase in the number of redundancy bits and related memory modules.

The variation in the number (p—h) of redundancy bits (it can be also carried out independently of the increase in information bits) will involve the variation in the number of both related memory modules ME(Fig. 1) and connection wires 101 (Fig. 6), added to the variations inside blocks GH, CM3, DE2 (Fig. 7) of correction logic LC.

In particular, if Hamming code is always used for the correction, the words to be stored can contain 16 information bits and 6 redundancy bits: this allows the detection also of double errors.

5) Writing in the spare module data from a module to be substituted

The bit organization providing, besides modules ME(i)...ME(p) intended to store the redundancy bits necessary for the self-correction, one or more modules ME(p+1) with spare reliability functions, that is one or more modules intended to replace one or more failed modules through a reconfiguration, involves the writing in the spare module of the data contained in the substituted module. This presents great reliability advantages and allows the restoration of the memory system without service interruptions.

If data of module ME(1) are stored in module ME(p+1) since the beginning of memory operation, this embodiment allows that correction logic LC controls also spare module ME(p+1), as described in the following.

Multiplexer MX(p+1) is enabled during write modes by signal CK2; the switching among its different inputs is controlled by the bit pattern present on connection 27.

The scheme of Fig. 6a refers to case of only one reliability spare module ME(p+1). If several spare modules are requested, some variations to PS structure are necessary and in particular:

— each spare module is connected to both a multiplexer similar to MX(p+1) and an additional input of multiplexers MX(1)...MX(p);
— the bit pattern conveyed by the controller on connection 27 must indicate the identity of the damaged module or modules as well as the expected reconfiguration scheme.

Then, decoder DE3 can be replaced by a read-only memory, addressed by said bit pattern.

In the particular case of only two spare modules, two decoders, similar to DE3 and each connected to one of the spare modules, can be sufficient.

The operation of the circuit PS is demanded if a reconfiguration is requested.

As to reconfiguration, a distinction is necessary between an effective reconfiguration, entailed by a memory error, or a fictitious reconfiguration, requested by the controller, only for supervision purposes of the correct operation of the spare module.

The second case is firstly described; this reconfiguration is allowed by both the presence and the particular connection of (p+1)-th input of MX(p+1) (wire 102), assumed to be steadily connected to wire 100(1).

This fictitious reconfiguration implies that the controller conveys on connection 27 a bit configuration entailing MX(p+1) switching from input 102 to input 100(1); furthermore, this bit configuration is decoded by DE3, which emits signal s(1) and entails MX(1) switching on the input connected to ME(p+1).

The reconfiguration is only fictitious, because, as already said, ME(1) and ME(p+1) present the same data.

Nevertheless, during the read mode, data are taken from ME(p+1) rather than from ME(1) and are controlled and possibly corrected by LC (Fig. 7), as already described with reference to the embodiment shown in Figs. 1 to 7. Obviously, no variations occur in read modes.

In case of effective failure, the identity of the faulty module is sent to the controller by LC (Fig. 7) through register RE10 and wire 92. On the basis of said information, the controller sends on connection 27 (Fig. 6a) the switching order.

If the failure occurs in module ME(1), the situation already described for the fictitious reconfiguration occurs.

On the contrary, if the failure occurs in a module different from ME(1), for instance ME(h), DE3 emits signal s(h) and entails MX(h) switching from the first to the second input.

As spare module ME(p+1) does not contain the same data of ME(h), the system should be initialized again, i.e. the memory should be rewritten, so as ME(p+1) contains the requested data.

From now on, the operations are repeated in an unchanged way. The new initialization can be avoided in some particular cases, when, for example, the memory is cyclically written: the data read on the spare module are automatically corrected by LC (Fig. 7) and rewritten into ME(p+1) (Fig. 1) within a memory cycle.

This procedure presents a disadvantage; in fact, if the correction logic allows only the correction of an error at a time, all its correction capacity would be engaged for the reconstruction of the correct data as long as the spare module is not rewritten: if an error occurs in another module, the correction logic could not intervene and the system would be out of order.

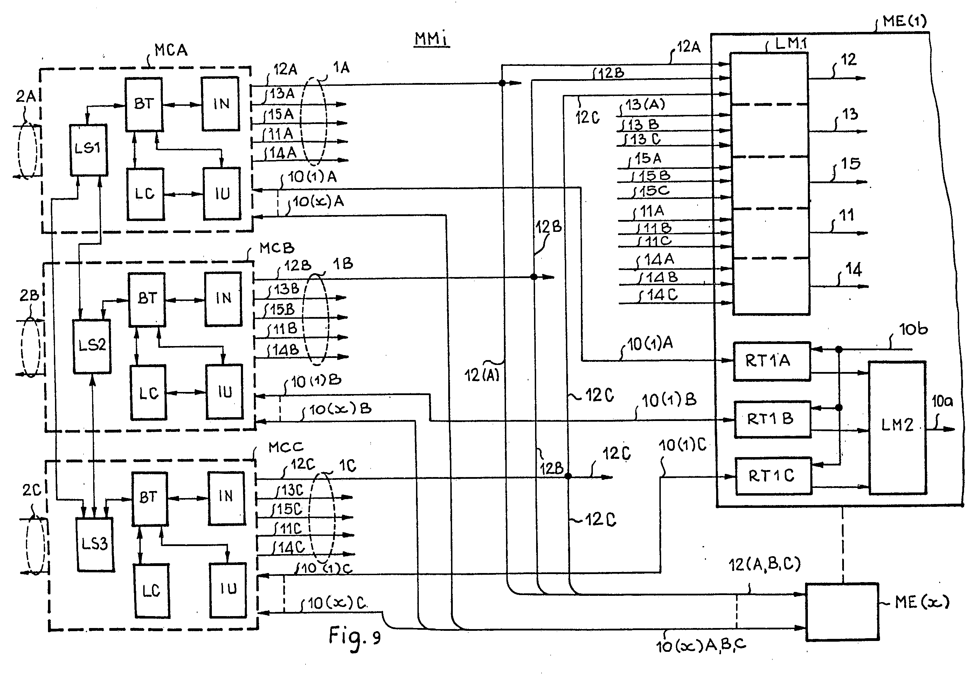

Fig. 9 shows a possible embodiment of a fully redundant memory unit MM, presenting not only spare memory modules, but also several control modules.

The full redundancy allows an improvement in the reliability performance of the mass-memory, as also the errors of the control modules can be corrected.

Memory unit MM, shown in Fig. 12, includes three control modules MCA, MCB, MCC and x memory modules. A certain number p of these memory modules is intended, as in Fig. 1, to store both information bits and redundancy bits necessary for self-correction; the remaining x-p modules are spare modules. Control modules MCA, MCB, MCC still contain time base BT, addressing control device IN, correction logic LC and input-output unit IU (equipped with the switching points), as in the embodiment of the unique control module; furthermore, each module MC comprises a respective synchronization logic LS1, LS2 or LS3 connected to both time base BT of the same control module and synchronization logics of the other modules, able to synchronize the three time bases.

The triplication of a time base for reliability purposes is known to the technicians of the art; an example is described in DE—A1 26 55 443.

The three control modules are connected both to the controller through the respective bidirectional connections (or pairs of unidirectional connections) 2A, 2B, 2C and to all the memory modules through wires or connections 10(1)A...10(x)A, 11A, 12A, 13A, 14, 15A (and 10(1)B to 15B and 10(1)C to 15C, respectively), corresponding to wires and connections 10 to 15 described with reference to the previous embodiment.

For sake of simplicity, wires and connections 2, 10 to 15 are connected generally to blocks MC and not to MC devices, from which they really come.

The Figures shows also, for memory module ME(1), the changements made necessary by the triplication of the control module. In particular, the five terns of wires and connections 11(A, B, C), 12(A, B, C), 13(A, B, C), 14(A, B, C), 15(A, B, C) reach as many sections of a majority logic LM1; each section emits as output a signal similar to that present at two inputs, at least. Outputs 11, 12, 13, 14, 15 of logic LM1 are the inputs of module ME, shown in Fig. 2, denoted by the same references.

Wires 10(1)A, 10(1)B, 10(1)C are connected to three transceivers RT1A, RT1B, RT1C (equal to transceiver RT1 of Fig. 2); they send the signals to be written into the memory to the three inputs of a second majority logic LM2, which emits the signal present at two inputs, at least; output 10a of LM2 corresponds exactly to output 10a of transceiver RT1 of Fig. 2.

The data read in the memory and present on wire 10b are sent, at the same time, to three transceivers RT1A, RT1B and RT1C and on their turn to the respective control modules MCA, MCB, MCC.

The statement relative to memory module ME(1) holds, obviously, also for all the other memory modules: each module presents a first majority logic, which receives the five terns of wires or connections 11(A, B, C) to 15(A, B, C), three transceivers which receive the three wires 10 relative to that module and a second logic downstream the three transceivers.

Several modifications and changements may be introduced in the realization of the device herein described without going out of the frame of the invention.

In particular, we referred to bidirectional transmission lines for the signals read in the memory or to be written in the memory. If different lines are used for the two transmission directions, transceivers RT2, RT3 of input-output units IU (Figure 6) would be no more necessary; furthermore,

switching point PS would not entail any more the presence of buffer BU (Fig. 6a) and the use of tri-state components.

The simplification of input-output unit, allowed by the use of unidirectional transmission lines, would be balanced by the impossible operation control of IU through circuits CM4 and RE9 of Fig. 7, which can operate because of the coupling between the two transmission directions just allowed by RT2 and RT3 (Figs. 6). Therefore, the technician should estimate each time the most useful embodiment, i.e. uni or bidirectional lines.

Furthermore, Fig. 9 shows an embodiment with tripled control module, being self-corrective also for control equipment.

Different redundancy embodiments would be also possible, for instance, with only duplicated control module; this embodiment entails a supervision of the reconfiguration which often implies other quipments and thus other complex circuits.

If the added equipment does not detect the failures, the two blocks should detect their failures; this entails a further duplication of each block to obtain a self-diagnosis with a sufficient coverage and in short times.

## Claims

1. Self-correcting and reconfigurable solid-state mass-memory organized in bits, consisting of at least one memory unit (MM1...MMi) comprising a first group of memory modules [ME(1)...ME(p)] each intended to store one bit of a plurality of words consisting of information bits and redundancy bits necessary to self-correction, one or more spare memory modules [ME(p+1)...ME(x)] which in case of failure have to replace one or more modules in the first group, and at least a control module (MC) controlling the data exchange between the memory unit (MM1...MMi) and a controller (C'1...C'i) and generating timing and addressing signals for the memory unit and supervising the operation of the memory unit by detecting and correcting errors, said control module (MC) comprising also switching means (PS) for switching out a failed memory module [(ME(1)...ME(p)] and switching in a spare memory module, the mass-memory being characterized in that said switching means (PS) consist of:

— a first group of multiplexers (MX1 ... MXp) which in case of right operation, are able to introduce in the control module (MC) the data read in the memory modules [ME(1)...ME(p)] of said first group and, in case of failure, to introduce in the control module the data read in the spare memory module or modules [ME(p+1)], each multiplexer presenting a first input connected to one of the memory modules [ME(1)...ME(p)] of said first group, one or more additional inputs, where each is connected to one of said spare modules, and an output connected to one of the transmission lines [100(1)...100(p)] which, in the absence of faults, convey the bits read in the memory module [(ME(1)...ME(p)] connected to the first input;

— one or more additional multiplexers [MX(p+1)], as many as the spare memory modules, able to supply, in case of failure, the data to be written also to the spare memory module or modules, said additional multiplexer [(MX(p+1)] or multiplexers presenting a plurality of inputs, where each is connected to one of the transmission lines [100(1)...100(p)] which convey the data to be written in the memory, and an output connected to the spare memory module or one of the spare memory modules;

— decoding means (DE3), able to receive from the controller a code, monitoring which memory module/modules is/are faulty and to generate signals which, in the multiplexer or multiplexers [MX(1)...MX(p)] associated with the faulty modules, entail the switching on of one of said additional inputs, said code outgoing from the controller entailing also the setting of the additional multiplexer [MX(p+1)] or of one or more of said additional multiplexers on the input connected to the transmission line associated with the module or one of the modules to be replaced.

2. Mass-memory according to claim 1, characterized in that each spare memory module [ME(p+1)] stores the same data of a memory module [ME(1)...ME(p)] of the first group; in that said additional multiplexer [MX(p+1)] or each of said additional multiplexers presents an additional input (102) on which the multiplexer sets itself under right operation conditions of the memory and which is steadily connected to the input which receives the data intended for said memory module [ME(1)...ME(p)] of the first group; and in that said code supplied by the controller can be a fictitious failure signalling which refers to said memory module [ME(1)...ME(p)] of the first group and entails the related switching of the involved multiplexers [MX(1)...MX(p+1)]

allowing the control and correction of the data loaded in said spare module or modules.

3. Mass-memory according to claim 1 or 2, characterized in that said switching means comprise also a set of buffers (BU) inserted on the lines conveying the data to the memory modules, said buffers being enabled only during memory write modes.

4. Mass-memory according to any of claims 1 to 3, characterized in that for connection to a triplicate controle module (MCA, MCB, MCC) each memory module [ME(1)...ME(x)] comprises:

— three data transceivers (RT1A, RT1B, RT1C), each connected, on one side, to one of the control modules (MCA, MCB, MCC) through a respective data transmission line [10(1)A...10(1)C...10(x)C] and, on the other side, to all memory circuits in the memory module and to an input of a first majority logic (LM2), which receives from each transceiver (RT1A, RT1B, RT1C) the bit to be written in the memory, as supplied by the respective control module (MCA, MCB, MCC) and supplies to the involved memory circuit the bit present on two inputs, at least;

— a second majority logic (LM1) which has terns of inputs respectively connected to wires or connections that, in three unidirectional buses (1A, 1B, 1C) transferring the timing and addressing signals from a respective control module (MCA, MCB, MCC) to the memory module, convey homologous signals, the second majority logic (LM2) having an output for each tern of inputs which receives the signal present on at least two inputs in the tern, the outputs of the second majority logic being connected to means that, in the module, allow the reception of the timing and addressing signals.

## Patentansprüche

1. Sich selbst korrigierender rekonfigurabler und bitorganisierter Massenspeicher aus wenigstens einer Speichereinheit (MM1...MMi), die eine erste Gruppe von Speichermoduln [ME(1)...ME(p)], von denen jeder dem Speichern je eines Bits von vielen Wörten, die aus Informationsbits und für die Selbstkorrektur erforderlichen Redundanzbits bestehen, dienen, ein oder mehrere Reserve-Speichermoduln [ME(p+1)...ME(x)], die im Fall eines Ausfalls einen oder mehrere Moduln in der ersten Gruppe ersetzen sollen, und wenigstens einen Steuermodul (MC), der den Datenaustausch zwischen der Speichereinheit (MM1...MMi) und einen Steuergerät (C'1...C'i) steuert und Zeitsteuer- und erzeugt sowie den Betrieb der Speichereinerzeugt sowie den betrieb der Speichereinheit durch Feststellen und Korrigieren von Fehlern überwacht, umfaßt, wobei der Steuermodul (MC) auch Umschalteinrichtungen (PS) zum Abhängen eines ausgefallenen Speichermoduls [ME(1)...ME(p)] und zum Einschalten eines Reserve-Speichermoduls [ME(p+1)] umfaßt, dadurch gekennzeichnet, daß die Umschalteinrichtungen (PS) aus folgenden Einzelschaltungen bestehen:

— einer ersten Gruppe von Multiplexern (MX1...MXp), die im Fall richtiger Operation in den Steuermodul (MC) die in den Speichermoduln [ME(1)...ME(p)] der ersten Gruppe gelesenen Daten einführen und im Fall einer Fehloperation in den Steuermodul die im Reserve-Speichermodul oder den Reserve-Speichermoduln [ME(p+1)] gelesenen Daten einführen, wobei jeder Multiplexer einen ersten mit einem der Speichermoduln [(ME(1)...ME(p)] der ersten Gruppe verbundenen Eingang, einen oder mehrere jeweils mit einem der Reserve-Speichermoduln verbundenen zusätzlichen Eingang bzw. Eingänge und einem mit einer von mehreren Sendeleitungen [100(1)...100(p)], die, wenn keine Fehloperation vorliegt, die im mit dem ersten Eingang verbundenen Speichermodul [ME(1)...ME(p)] gelesenen Bits führen, verbundenen Ausgang aufweist;

— einem oder mehreren zusätzlichen Multiplexern [MX(p+1)] in gleicher Zahl, als Reserve-Speichermoduln vorhanden sind, der bzw. die im Fall einer Fehloperation die zu schreibenden Daten auch dem Reserve-Speichermodul bzw. den Reserve-Speichermoduln liefert/liefern und jeweils eine Mehrzahl von Eingängen, von denen jeder mit einer der Sendeleitungen [100(1)...100(p)] verbunden ist, welche die im Speicher zu schreibenden Daten befördern, sowie einen Ausgang, der mit dem Reserve-Speichermodul bzw. einem der Reserve-Speichermoduln verbunden ist, aufweist/aufweisen;

— einer Decodereinrichtung (DE3), die vom Steuergerät (C'1...C'i) einen Code empfängt, der anzeigt, welcher Speichermodul bzw. welche Speichermoduln fehlerhaft ist bzw. sind, und die Signale erzeugt, die im Multiplexer oder in den Multiplexern [MX(1)...MX(p)], die den fehlerhaften Moduln zugeordnet sind, das Schalten auf einen der zusätzlichen Eingänge bewirken, wobei der von dem Steuergerät ausgehende Code bewirkt, daß auch der zusätzliche Multiplexer [MX(p+1)] oder einer oder mehrere der zusätzlichen Multiplexer auf den Eingang gestellt wird, der mit der dem zu ersetzenden Modul oder einem der zu ersetzenden Moduln zugeordneten Sendeleitung verbunden ist.

2. Massenspeicher nach Anspruch 1, dadurch gekennzeichnet, daß jeder Reserve-Speichermodul [ME(p+1)] die selben Daten wie eines der Speichermoduln [ME(1)...ME(p)] der ersten Gruppe speichert; daß der zusätzliche Multiplexer [MX(p+1)] oder jeder der zusätzlichen Multiplexer einen zusätzlichen Eingang (102) aufweist, auf den sich der Multiplexer selbst unter richtigen Betriebsbedingungen des Speichers setzt und der ständig mit dem Eingang verbunden ist, der die für diesen Speichermodul [ME(1)...ME(p)] der ersten Gruppe bestimmten Daten empfängt; und daß der vom Steuergerät gelieferte Code eine fiktive Fehlersignalisierung sein kann, die sich auf den Speichermodul [ME(1)...ME(p)] der ersten Gruppe bezieht und das diesbezügliche Schalten der beteiligten Multiplexer [MX(1)...MX(p+1)] bewirkt, wodurch die Steuerung und Korrektur der im Reservemodul bzw. in den Reservemoduln geladenen Daten ermöglicht wird.

3. Massenspeicher nach Anspruch 1 oder 2, dadurch gekennzeichnet, daß die Umschalteinrichtungen weiterhin eine Gruppe von Puffern (BU) umfassen, die auf den die Daten zu den Speichermoduln befördernden Leitungen eingesetzt sind und nur während des Speicher-Schreibmodus in Tätigkeit gesetzt sind.

4. Massenspeicher nach einem der Ansprüche 1 bis 3, dadurch gekennzeichnet, daß zum Anschluß an einen dreifachen Steuermodul (MCA, MCB, MCC) jeder Speichermodul [ME(1)...ME(x)] folgende Einzelschaltungen enthält:

— drei Daten-Senderempfänger (RT1A, RT1B, RT1C), von denen jeder an einer Seite über eine entsprechende Datensendeleitung [10(1)A...10(1)C...10(x)C] mit einem der Steuermoduln (MCA, MCB, MCC) verbunden ist und an der anderen Seite mit allen Speicherschaltungen im Speichermodul und mit einem Eingang einer ersten Majoritätslogik (LM2) verbunden ist, die von jedem der Senderempfänger (RT1A, RT1B, RT1C) das im Speicher zu schreibende Bit, wie es vom betreffenden Steuermodul (MCA, MCB, MCC) geliefert wird, empfängt und an die beteiligte Speicherschaltung das an wenigstens zwei Eingängen anliegende Bit liefert;

— eine zweite Majoritätslogik (LM1) mit Dreiergruppen von Eingängen, die jeweils mit Leitern oder Verbindungen verbunden sind, die über drei in einer Richtung wirkende Sammelleitungen (1A, 1B, 1C), welche die Zeit- und Adressensignale von einem entsprechenden Steuermodul (MCA, MCB, MCC) zum Speichermodul übertragen, homologe Signale führen, wobei die zweite Majoritätslogik (LM1) einen Ausgang (12...14) für jede Dreiergruppe von Eingängen aufweist, der das an wenigstens zweien der Eingänge in der Dreiergruppe anliegende Signal empfängt, und diese Ausgänge der zweiten Majoritätslogik mit einer Einrichtung verbunden sind, die im Modul den Empfang der Zeitsteuer- und Adressensignale freigibt.

## Revendications

1. Mémoire de masse à état solide autocorrectrice, organisée par bits et susceptible de reconfiguration comportant au moins une unité de mémoire (MM1...MMi) qui comprend un premier groupe de modules de mémoire [ME(1)...ME(p)] dont chacun est destiné à emmagasiner un bit d'une pluralité de mots constitués de bits d'information et de bits de redondance nécessaires à l'autocorrection, un ou plusieurs modules de mémoire de réserve [ME(p+1)...ME(x)] qui, en cas de défaillance, doivent remplacer un ou plusieurs modules du premier groupe, et au moins un module de commande (MC) qui commande l'échange des données entre l'unité de mémoire (MM1...MMi) et un contrôleur (C'1...C'i) engendre des signaux de synchronisation et d'adressage destinés à l'unité de mémoire et supersize le fonctionnement de l'unite de mémoire à l'aide de la détection et correction des erreurs, ledit module de commande (MC) comportant également des moyens de commutation (PS) capables de produire une commutation entre un module de mémoire défaillant [ME(1)...ME(p)] et un module de réserve, la mémoire de masse étant caractérisée en ce que lesdits moyens de commutation comprennent:

— un premier groupe de multiplexeurs (MX1...MXp) qui, en cas de fonctionnement correct, sont capables d'introduire dans le module de commande (MC) les données lues dans les modules de mémoire [ME(1)...ME(p)] dudit premier groupe et, en cas de défaillance, d'introduire dans le module de commande les données lues dans le ou les modules de réserve [ME(p+1)], chaque multiplexeur présentant une première entrée connectée à l'un des modules de mémoire [ME(1)...ME(p)] dudit premier groupe, une ou plusieurs entrées supplémentaires dont chacune est connectée à l'un desdits modules de réserve, et une sortie connectée à l'une des lignes de transmission [100(1)...100(p)] qui, en l'absence de défaillance, transportent les bits lus dans le module de mémoire [ME(1)...ME(p)] connecté à la première entrée;

— un ou plusieurs multiplexeurs supplémentaires [MX(p+1)], en nombre égal à celui des modules de mémoire de réserve, capables de délivrer également, en cas de défaillance, les données a écrire au ou aux modules de mémoire de réserve, ce ou ces multiplexeurs supplémentaires [MX(p+1)] presentant plusieurs entrées dont chacune est connectée à l'une des lignes de transmission [100(1)...100(p)] qui acheminent vers la mémoire les données à écrire, et une sortie connectée au module de mémoire de réserve ou à l'un des modules de mémoire de réserve;

— des moyens décodeurs (DE3) capables de recevoir du contrôleur un code avertisseur de celui ou de ceux des modules de mémoire qui est/sont défaillant (s) et de générer des signaux qui, dans le ou les multiplexeurs [MX(1)...MX(p)] associés aux modules défaillants, entrainent la commutation sur l'une desdites entrées supplémentaires, le code en provenance du contrôleur provoquant également le positionnement du multiplexeur supplémentaire [MX(p+1)] ou de l'un ou plusieurs des multiplexeurs supplémentaires sur l'entrée connectée à la ligne de transmission associée au module ou à l'un des modules à remplacer.

2. Mémoire de masse selon la revendication 1, caractérisée en ce que chaque module de mémoire de réserve [ME(p+1)] emmagasine les mêmes données qu'un module de mémoire [ME(1)...ME(p)] du premier groupe; en ce que le multiplexeur supplémentaire [MX(p+1)] ou chacun des multiplexeurs supplémentaires présente une entrée supplémentaire (102) sur laquelle le multiplexeur se positionne dans les conditions de fonctionnement correct de la mémoire et qui est connectée en permanence à l'entrée qui reçoit la donnée destinée audit module de mémoire [ME(1)...ME(p)] du premier groupe; et en ce que le code fourni par le contrôleur peut être une indication de défaillance fictive qui se rapporte audit module de mémoire [ME(1)...ME(p)] du premier groupe et provoque le commutation correspondante des multiplexeurs [MX(1)...MX(p+1)] concernés, ce qui permet le contrôle et la correction des données chargées dans le ou les modules de réserve.

3. Mémoire de masse selon la revendication 1 ou 2, caractérisée en ce que les moyens de commutation comprennent également un jeu d'amplificateurs (BU) intercalé sur les lignes qui acheminent les données vers les modules de mémoire, ces amplificateurs étant validés seulement dans les modes d'écriture en mémoire.

4. Mémoire de masse selon l'une quelconque des revendications 1 à 3, caractérisée en ce que pour la connexion à un module de commande tripliqué, chaque module de mémoire comprend:

— trois émetteurs-récepteurs de données (RT1A, RT1B, RT1C) connectés chacun, d'un côté à l'un des modules de commande (MCA, MCB, MCC) par une ligne respective de transmission de données [10(1)A...10(1)C...10(x)A...10(x)C] et de l'autre côté, à la fois à tous les circuits de mémoire du module et à une entrée d'une première unité logique de majorité (LM2) qui reçoit de chaque émetteur-récepteur (RT1A, RT1B, RT1C) le bit à écrire dans la mémoire, fourni par le module de commande (MCA, MCB, MCC) respectif, et délivre au circuit de mémoire concerné le bit présent au moins à deux entrées;

— une seconde unité logique de majorite (LM1) qui présente des ternes d'entrées connectées au fils ou groupes de fils qui, dans trois bus unidirectionnels (1A, 1B, 1C) transfèrant les signaux de synchronisation et d'adressage trois bus unidirectionnels (1A, 1B, 1C) transfèrant les signaux du module de commande (MCA, MCB, MCC) respectif au module de mémoire, acheminent des signaux homologues, la seconde logique de majorité (LM1) ayant une sortie pour chaque terne d'entrées qui reçoit le signal présent à deux entrées au moins de la terne, les sorties de cette seconde logique de majorité étant connectées à des moyens qui, dans le module, permettent la réception des signaux de synchronisation et d'adressage.

Fig. 1

Fig.2

Fig.3

2

Fig. 4

0 006 550

Fig. 5

Fig. 6

4

Fig. 6a

Fig. 7

Fig. 8 b

Fig. 8 c

0 006 550

CKO

Φ₁

Φ₂

Fig. 8a

Φ₁  1    2    3

Φ₂

A=B

DPR

FL

CK1

CK2

WE

Fig. 8d

0 006 550

8

Fig. 9